# EUROPÄISCHE PATENTSCHRIFT

(11) **EP 2 054 951 B1**
(45) Veröffentlichungstag und Bekanntmachung des Hinweises auf die Patenterteilung: **18.05.2011**
(21) Anmeldenummer: 07817689.8
(22) Anmeldetag: 17.10.2007
(51) Int. Cl.: H01L 41/083, H01L 41/047, H01L 41/107

(54) **PIEZOELEKTRISCHES BAUELEMENT**
PIEZOELECTRIC COMPONENT
COMPOSANT PIÉZOÉLECTRIQUE

(30) Priorität: 19.10.2006 DE 102006049323
(43) Veröffentlichungstag der Anmeldung: 06.05.2009
(73) Patentinhaber: Epcos AG, 81669 München (DE)
(72) Erfinder: FLORIAN, Heinz, 8524 Bad Gams (AT); GLAZUNOV, Alexander, 8530 Deutschlandsberg (AT); KARTASHEV, Igor, 8530 Deutschlandsberg (AT)
(74) Vertreter: Epping - Hermann - Fischer
(86) Internationale Anmeldenummer: PCT/DE2007/001854
(87) Internationale Veröffentlichungsnummer: WO 2008/046406

(56) Entgegenhaltungen:
- EP-A- 1 835 553
- DE-A1-102004 012 033
- DE-A1-102004 043 525
- JP-A- 2002 289 935
- JP-A- 2003 243 738

## Beschreibung

Ein piezoelektrisches Bauelement ist z. B. aus der Druckschrift DE 102004043525 A1 oder US 6,414,417 B1 bekannt.

JP 2002 289935 A zeigt ein piezoelektrisches Bauelement nach dem Oberbegriff des Anspruchs 1. Weitere piezoelektrische Bauelemente mit Kontaktierungen für Kanten von Innenelektroden, die an seitliche Vertiefungen eines Bauelementkörpers heranreichen, sind aus JP 2003 243738 A und EP 1835553 A1 bekannt.

DE 10 2004 012 033 A enthält Größenangaben betreffend die Abmessungen seitlicher Vertiefungen im Körper eines piezoelektrischen Bauelements. DE 10 2004 043 525 A zeigt schematisch elektische Anschlussdrähte für Innenelektroden.

Es ist die Aufgabe der vorliegenden Erfindung, ein piezoelektrisches Bauelement mit erhöhter Zuverlässigkeit bereitzustellen. Insbesondere soll das Risiko verringert werden, dass einzelne Elektroden des Bauelements vollständig ausfallen.

Es wird ein piezoelektrisches Mehrschicht-Bauelement mit einem Körper angegeben, in dem Piezoschichten und Innenelektroden abwechselnd angeordnet sind, wobei mindestens eine Kante der jeweiligen Innenelektrode in eine an der Oberfläche des Körpers ausgebildete Vertiefung mündet.

Die Vertiefung ist vorzugsweise als eine Rille ausgebildet, die sich entlang der Kante der jeweiligen Innenelektrode erstreckt.

Für jede Innenelektrode ist mindestens eine eigene Vertiefung vorgesehen. Es können auch mehrere Vertiefungen für jede Innenelektrode vorgesehen sein.

Die Oberfläche der Vertiefung ist erfindungsgemäß mit einer elektrisch leitfähigen Beschichtung bedeckt. Die Vertiefung weist hierzu beispielsweise eine Metallisierung oder eine andere elektrisch leitfähige Schicht z. B. aus Keramik auf. Die Metallisierung kann das gleiche Material enthalten wie die Innenelektroden. Die Metallisierung kann z. B. Aluminium, Kupfer oder Silber enthalten.

Zur Lösung der der Erfindung zugrunde liegenden Aufgabe ist vorgesehen, dass zumindest in einem Teilbereich des Körpers des piezoelektrischen Mehrschicht-Bauelements die Innenelektroden jeweils mindestens zwei parallel geschaltete Teilelektroden aufweisen, die an ein und derselben Vertiefung münden und über die Metallisierung bzw. über die elektrisch leitfähige Beschichtung dieser Vertiefung leitend miteinander verbunden sind.

Hierdurch wird die Zuverlässigkeit des piezoelektrischen Bauelements erhöht, da ein Ausfall einer Teilelektrode nicht zu einem Ausfall der jeweiligen Elektrode, zu der die Teilelektrode gehört, führt.

Das angegebene Mehrschicht-Bauelement kann z. B. ein Piezoaktor oder ein Piezotransformator sein. Der Piezotransformator umfasst einen Eingangsteil, einen Ausgangsteil und einen zwischen diesen angeordneten Isolierbereich, der zur mechanischen Kopplung zwischen dem Ein- und Ausgangsteil dient. Der Teilbereich des Körpers des piezoelektrischen Mehrschicht-Bauelements, in dem die Innenelektroden jeweils mindestens zwei parallel geschaltete Teilelektroden aufweisen, kann insbesondere der Ausgangsteil sein. Der Eingangsteil ist vorzugsweise ein Niederspannungsteil und der Ausgangsteil ein Hochspannungsteil des Transformators, d. h. die Ausgangsspannung des Transformators ist größer als die Eingangsspannung.

Die Piezoschichten enthalten vorzugsweise ein Keramikmaterial. Diese Schichten umfassen vorzugsweise ein Blei-Zirkonat-Titanat (PZT) oder ein anderes Material mit piezoelektrischen Eigenschaften. Zur Polarisation der jeweiligen Piezoschicht wird eine Spannung z. B. im Bereich 2-4 kV/mm benutzt.

Die Innenelektroden umfassen erste und zweite Innenelektroden, die abwechselnd angeordnet sind. Die ersten Innenelektroden sind einer ersten Polarität und die zweiten Innenelektroden einer zweiten Polarität zugeordnet. Die Vertiefungen, in die die ersten Innenelektroden münden, sind vorzugsweise an einer ersten Seitenfläche und die Vertiefungen, in die die zweiten Innenelektroden münden, an einer der ersten Seitenfläche gegenüberliegenden zweiten Seitenfläche des Körpers angeordnet.

Vorzugsweise wird jede Innenelektrode durch einen eigenen Anschlussdraht kontaktiert, der mit der Metallisierung der jeweiligen Vertiefung z. B. mittels einer Lotmasse verbunden werden kann. Die Metallisierungen unterschiedlicher Vertiefungen sind vorzugsweise voneinander beabstandet und nicht über elektrische Verbindungen miteinander verbunden, die im Körper oder an der Körperoberfläche angeordnet sind. Die elektrische Verbindung einer jeden Innenelektrode erfolgt dann über Anschlussdrähte, die in einem Abstand vom Körper leitend miteinander verbunden sind.

Das angegebene Bauelement ist in einer vorteilhaften Variante frei von großflächigen Außenelektroden, die an Seitenflächen des Körpers angeordnet sein könnten. Somit muss eine Innenelektrode nicht mehr von der Seitenfläche beabstandet sein, an der die Außenelektrode der anderen Polarität angeordnet wäre. Somit gewinnt man an der Fläche der Innenelektrode und letztlich am elektromechanisch aktiven Volumen des Bauelements. Außerdem lässt sich ein besonders großer Anteil der Piezoschicht gleichmäßig polarisieren, da inaktive Randbereiche, in denen keine Überlappung unterschiedlich gepolter Innenelektroden erfolgt, ausgeschlossen werden.

Alternativ kann ein sehr kleiner Abstand zwischen der jeweiligen Innenelektrode und der Seitenfläche des Körpers eingestellt sein, an der die Innenelektroden der jeweils anderen Polarität münden. Dieser Abstand wird nun so gewählt, dass er den Abstand zwischen zwei Innenelektroden unterschiedlicher Polarität nicht übersteigt. Diese Ausführung zeichnet sich einerseits durch besonders kleine inaktive Randbereiche und andererseits durch eine besonders hohe Durchschlagsfestigkeit aus, da die Innenelektroden von derjenigen Seitenfläche des Körpers zurückgezogen sind, an der die Innenelektroden der anderen Polarität kontaktiert werden.

Die Seitenfläche des Körpers, die senkrecht zu den Innenelektroden verläuft, ist vorzugsweise frei von Metallisierungen, insbesondere großflächigen Metallisierungen, ausgenommen die Metallisierung der Vertiefungen und/oder die frei liegenden Kanten der Innenelektroden. Es wurde erkannt, dass zwischen einer Metallfläche und einer Nadel oder einer scharfen Metallkante, die dieser Metallfläche gegenüber steht, beim Anlegen einer elektrischen Spannung eine deutliche höhere Feldstärke zustande kommt als zwischen zwei einander gegenüber liegenden Metallflächen. Nun wird auf eine Außenelektrode, d. h. eine große Metallfläche auf der Seitenfläche des Körpers, die nur einen geringen Abstand zur scharfen Kante der gegengepolten Innenelektrode hätte, verzichtet. Dadurch gelingt es, im Randbereich des Körpers eine hohe elektrische Feldstärke zu vermeiden. Somit kann die elektrische Durchschlagfestigkeit des Bauelements erhöht werden.

Die Vertiefungen können durch ein mechanisches Abtragen oder durch ein chemisches Ätzverfahren erzeugt werden. Die Metallisierung in den Vertiefungen kann unter Verwendung von Masken erzeugt werden. Dabei wird in den Vertiefungen vorzugsweise eine Metallpaste z. B. in einem Siebdruckverfahren aufgetragen und danach eingebrannt. Die Metallisierung kann auf die Oberfläche der Vertiefungen auch aufgedampft oder anderweitig - z. B. durch Galvanisieren - aufgetragen werden. Außerdem besteht die Möglichkeit, die mit den Vertiefungen versehene Seitenfläche des Körpers großflächig zu metallisieren und danach den außerhalb der Vertiefungen angeordneten Metallisierungsbereich z. B. durch Schleifen abzutragen.

Die Vertiefungen sind vorzugsweise im Querschnitt abgerundet. Die Tiefe der Vertiefung beträgt vorzugsweise maximal ein Zehntel des Abstands zwischen aufeinander folgenden, unterschiedlich gepolten Innenelektroden.

In jeder Vertiefung ist vorzugsweise mindestens ein Anschlussdraht z. B. durch eine Lötverbindung befestigt. Die Anschlussdrähte, die ein und derselben Polarität zugeordnet sind, sind alle an einen gemeinsamen elektrischen Anschluss angeschlossen.

Zwischen zwei aufeinander folgenden Teilelektroden der jeweiligen Innenelektrode ist eine elektrisch isolierende Schicht angeordnet, die vorzugsweise das gleiche, allerdings nicht polarisierte, Material enthält wie die zwischen zwei Innenelektroden angeordnete Piezoschicht.

Zumindest auf der Seitenfläche des Körpers kann eine elektrisch isolierende Schicht angeordnet sein, die insbesondere freiliegende Kanten der Innenelektroden überdeckt, die den an diese Innenelektrode angeschlossenen Anschlussdraht nicht berühren. Die isolierende Schicht kann Glas, SiO₂ oder ein organisches Material, insbesondere einen Lack, enthalten. Die isolierende Schicht wird vorzugsweise erst nach dem Befestigen von Anschlussdrähten in den Vertiefungen auf die Oberfläche des Körpers aufgetragen.

Das angegebene Mehrschicht-Bauelement wird nun anhand von schematischen und nicht maßstabgetreuen Figuren erläutert. Es zeigen im Querschnitt ausschnittsweise:
Figur 1 ein herkömmliches Mehrschicht-Bauelement mit in einem Körper angeordneten Innenelektroden, die sich auf allen Seiten bis zur Oberfläche des Körpers erstrecken;
Figur 2 ein weiteres herkömmliches Mehrschicht-Bauelement, bei dem die Innenelektroden auf einer Seite von der Oberfläche des Körpers zurückgezogen sind;
Figur 3 ein Ausführungsbeispiel eines erfindungsgemäßen Mehrschicht-Bauelements mit Innenelektroden, die mehrere Teilschichten aufweisen;
Figur 4 eine Erläuterung zur Messung der Breite und Tiefe der Vertiefung;
Figur 5 ein Ausführungsbeispiel eines erfindungsgemäßen Piezotransformators.

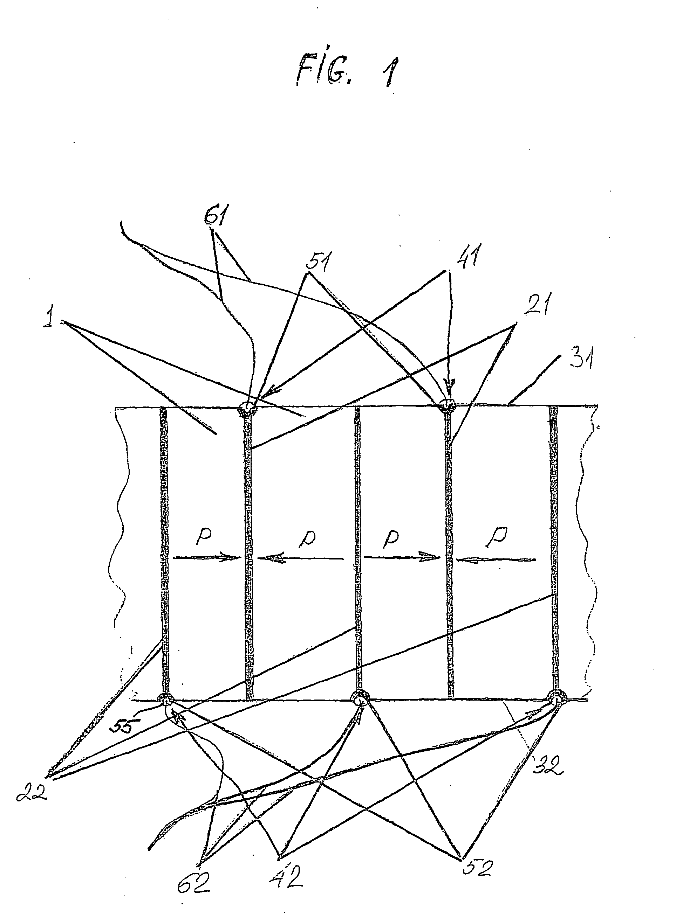

In der Figur 1 ist ein herkömmliches Mehrschicht-Bauelement mit mehreren Piezoschichten 1 gezeigt, zwischen denen Innenelektroden 21, 22 angeordnet sind. Erste Innenelektroden 21 und zweite Innenelektroden 22 sind abwechselnd angeordnet.

In der Variante gemäß der Figur 1 erstreckt sich jede Innenelektrode 21, 22 sowohl bis zu einer ersten Seitenfläche 31 als auch bis zur zweiten Seitenfläche 32 des Körpers. An der ersten Seitenfläche 31 sind im Bereich der bis dahin reichenden Kanten der ersten Innenelektroden 21 erste Vertiefungen 41 ausgebildet, die entlang dieser Kanten ausgerichtet sind. An der Oberfläche der Vertiefungen 41 ist eine Metallisierung 51 angeordnet.

An der zweiten Seitenfläche 32 sind im Bereich der Kanten der zweiten Innenelektroden 22 zweite Vertiefungen 42 ausgebildet, die entlang dieser Kanten ausgerichtet sind. An der Oberfläche der Vertiefungen 42 ist eine Metallisierung 52 angeordnet. In jeder Vertiefung ist vorzugsweise eine Lotmasse 55 zur Verbindung mit dem jeweiligen Anschlussdraht 61, 62 angeordnet.

Die ersten Innenelektroden 21 sind jeweils an mindestens einen ersten Anschlussdraht 61 angeschlossen. Die ersten Anschlussdrähte 61 sind alle an einen gemeinsamen elektrischen Anschluss des Bauelements angeschlossen. Somit sind die ersten Innenelektroden 21 zwar leitend miteinander verbunden, aber über eine elektrische Verbindung, die vom Körper beabstandet ist. Dies gilt auch für die zweiten Innenelektroden 22, die jeweils an mindestens einen zweiten Anschlussdraht 62 angeschlossen sind.

Die Piezoschicht 1, die zwischen unterschiedlich gepolten Elektroden 21, 22 liegt, ist polarisiert. Die Polarisationsrichtung der jeweiligen Piezoschicht 1 ist in den Figuren 1, 2, 3 mit einem Pfeil angedeutet.

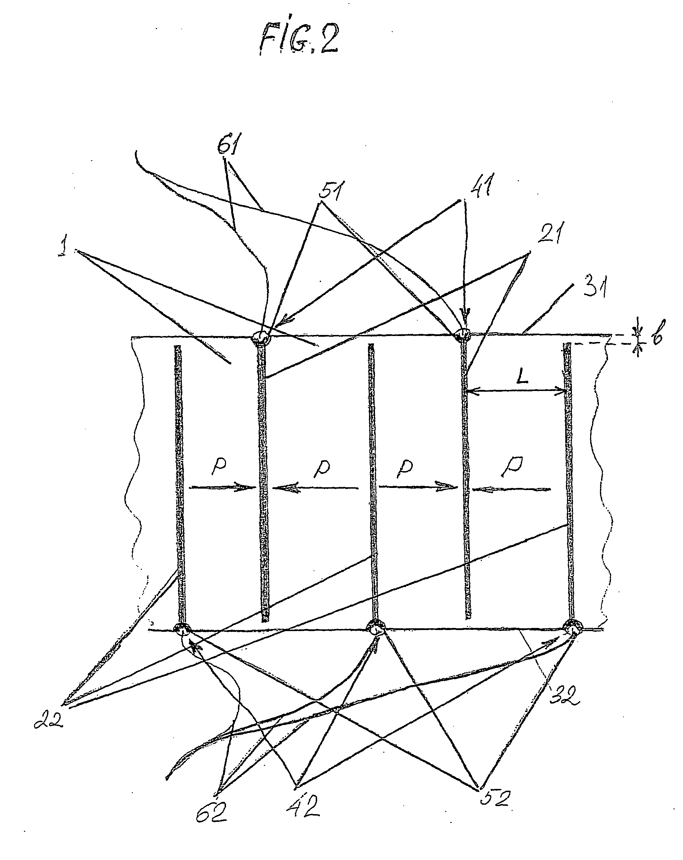

In der Variante gemäß der Figur 2 erstreckt sich jede erste Innenelektrode 21 bis zur ersten Seitenfläche 31, wobei sie von der zweiten Seitenfläche 32 des Körpers um einen Abstand b zurückgezogen ist. Umgekehrt erstreckt sich jede zweite Innenelektrode 22 bis zur zweiten Seitenfläche 32, wobei sie von der ersten Seitenfläche 31 des Körpers um einen Abstand b zurückgezogen ist. Der Abstand b ist vorzugsweise kleiner als die Dicke L der polarisierten Piezoschicht 1. Diese Dicke ist gleich dem Mindestabstand zwischen einer ersten Elektrode 21 und einer darauf folgenden zweiten Elektrode 22.

Die polarisierte Piezoschicht 1 umfasst eine Anzahl N übereinander gelegter piezoelektrischer Keramikfolien, deren Dicke z. B. zwischen 10 und 400 Mikrometer liegt. N ist eine ganze Zahl. Die Dicke L der polarisierten Piezoschicht 1 beträgt N x L. Im Schichtaufbau des Körpers werden aus technologischen Gründen vorzugsweise Keramikfolien mit der gleichen Dicke verwendet.

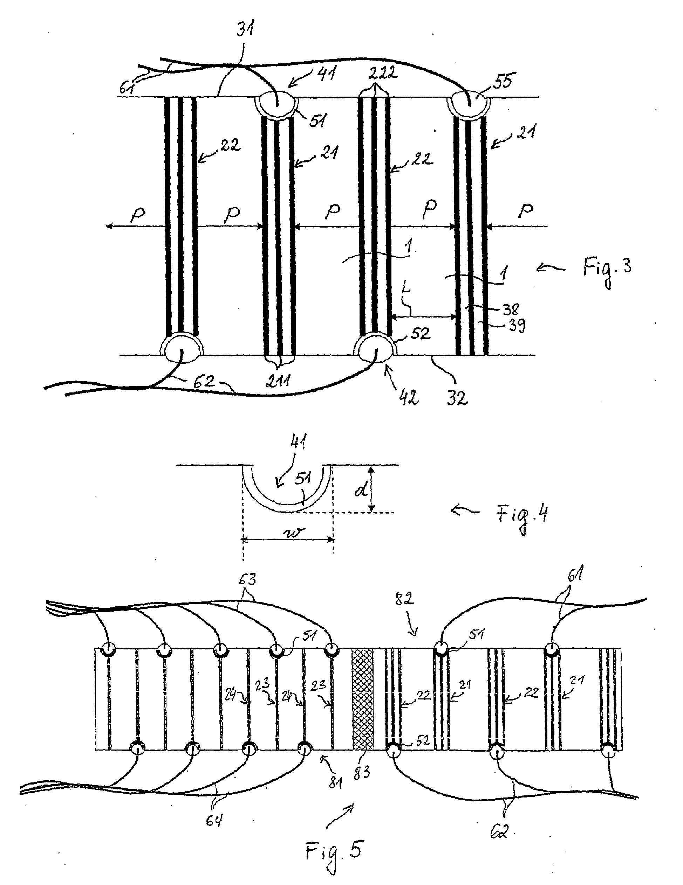

Die Breite w der Vertiefung 41 (siehe Figur 4) ist vorzugsweise kleiner als die Dicke L der Piezoschicht 1, so dass die die Innenelektrode 21 kontaktierende Metallisierung 51 der Vertiefung 41 von der benachbarten Innenelektrode 22 der anderen Polarität beabstandet ist. Dies gilt in entsprechender Weise auch für die Vertiefung 42.

In einer vorteilhaften Variante beträgt die Breite w der Vertiefung 41, 42 weniger als 0,2L. Die Tiefe d der Vertiefung ist vorzugsweise kleiner als 0,1L.

In der Figur 3 ist angedeutet, dass gemäß einer erfindungsgemäßen Ausführungsform des piezoelektrischen Bauelements die ersten Innenelektroden 21 jeweils mehrere Teilelektroden 211 und die zweiten Innenelektroden 22 jeweils mehrere Teilelektroden 222 aufweisen.

Die Teilelektroden 211, die ein und derselben Innenelektrode 21 angehören, sind an der ersten Seitenfläche 31 des Körpers über die Metallisierung 51 der Vertiefung 41 leitend miteinander verbunden. Die Teilelektroden 222, die ein und derselben Innenelektrode 22 angehören, sind an der zweiten Seitenfläche 31 des Körpers über die Metallisierung 52 leitend miteinander verbunden.

Die durch die Metallisierung 51, 52 parallel geschalteten Teilelektroden 211, 222 bilden jeweils eine Mehrfach-Elektrode 21 bzw. 22. Dies hat den Vorteil, dass beim Ausfallen einer der Teilelektroden nicht die ganze Elektrode 21, 22 ausfällt.

Die Parallelschaltung von dicht aufeinander folgenden Teilelektroden ist insbesondere im Hochspannungsteil 82 eines als Piezotransformator ausgebildeten Bauelements vorteilhaft, da dort der Abstand zwischen den ersten und zweiten Elektroden 21, 22 besonders groß ist, vgl. Fig. 5, so dass im Hochspannungsteil 82 verglichen etwa mit dem Niederspannungsteil 81 des Transformators insgesamt nur wenige Innenelektroden vorhanden sind.

Zwischen zwei ersten Teilelektroden 211, die zur jeweiligen ersten Elektrode 21 gehören, sowie zwischen zwei Teilelektroden 222, die zur jeweiligen zweiten Elektrode 22 gehören, ist eine Keramikschicht 38, 39 angeordnet, die vorzugsweise die Dicke einer Keramikfolie aufweist, die dem Schichtaufbau des Körpers zugrunde liegt. Die Keramikschichten 38, 39 sind im Gegensatz zu den Piezoschichten 1 nicht polarisiert, da sie zwischen zwei Teilelektroden liegen, die das gleiche elektrische Potential aufweisen.

Der in der Figur 5 vorgestellte Piezotransformator umfasst einen Eingangsteil 81, einen Ausgangsteil 82 und einen zwischen diesen angeordneten Isolierbereich 83.

Der Eingangsteil 81 weist erste Innenelektroden 23 und zweite Innenelektroden 24 auf und ist im Wesentlichen gemäß Fig. 1 oder 2 aufgebaut. Die ersten Innenelektroden 23 werden einzeln durch Anschlussdrähte 63 kontaktiert. Die zweiten Innenelektroden 24 werden einzeln durch Anschlussdrähte 64 kontaktiert.

Der Ausgangsteil 82 weist erste Innenelektroden 21 und zweite Innenelektroden 22 auf und ist im Wesentlichen gemäß Fig. 3 aufgebaut. Die Innenelektroden 21, 22 sind hier als Mehrfach-Elektroden ausgebildet.

Im Gegensatz zu bisher bekannten Piezotransformatoren erstrecken sich die Innenelektroden von der ersten bis zur zweiten Seitenfläche des Körpers.

Alternativ kann ein bestimmter relativ kleiner Abstand b zwischen der zweiten Seitenfläche 32 des Körpers und der ihr zugewandten Kante der ersten Innenelektrode 21 sowie zwischen der ersten Seitenfläche 31 des Körpers und der ihr zugewandten Kante der zweiten Innenelektrode 22 eingehalten sein, der die Dicke der Piezoschicht 1 nicht übersteigt.

Somit sind die Kanten der Innenelektroden im Körper einerseits vergraben und insbesondere von der frei liegenden Oberfläche des Körpers beabstandet, wodurch die Gefahr eines elektrischen Überschlags entlang der Oberfläche des Körpers ausgeschlossen wird.

Da aber großflächige Außenelektroden an den Seitenflächen des Körpers nun nicht vorhanden sind, besteht andererseits nicht die Gefahr eines elektrischen Überschlags zwischen der jeweiligen Innenelektrode und der ihr zugewandten Außenelektrode der anderen Polarität, die sonst sehr dicht neben ihr läge.

Besonders vorteilhaft ist die Einhaltung des Abstands b im Hochspannungsteil des Transformators. Aber auch im Niederspannungsteil kann es vorteilhaft sein, diesen Abstand einzuhalten.

### Bezugszeichenliste

- 1: Piezoschicht
- 61, 62: Anschlussdraht
- 21: erste Innenelektroden
- 211: Teilschichten der Innenelektrode 21
- 22: zweite Innenelektroden
- 222: Teilschichten der Innenelektrode 22
- 31: erste Seitenfläche des Körpers
- 32: zweite Seitenfläche des Körpers
- 38, 39: nicht polarisierte Keramikschichten
- 41, 42: Vertiefungen
- 51, 52: Metallisierung der Vertiefungen
- 55: Lot
- 81: Eingangsteil
- 82: Ausgangsteil
- 83: Isolierbereich
- b: Abstand zwischen Kante der ersten Elektrode und der zweiten Seitenfläche des Körpers, oder Abstand zwischen Kante der zweiten Elektrode und der ersten Seitenfläche des Körpers
- d: Tiefe der Vertiefung
- L: Abstand zwischen einander gewandten gegengepolten Elektroden
- P: Polarisationsachse
- w: Breite der Vertiefung

## Patentansprüche

1. Piezoelektrisches Mehrschicht-Bauelement
- mit einem Körper, in dem Piezoschichten (1) und Innenelektroden (21, 22) abwechselnd angeordnet sind,
- wobei mindestens eine Kante der jeweiligen Innenelektrode in eine an der Oberfläche des Körpers ausgebildete Vertiefung (41, 42) mündet, wobei die Innenelektrode an der Vertiefung nach außen kontaktiert ist,
- wobei die Oberfläche der jeweiligen Vertiefung (41, 42) eine elektrisch leitfähige Beschichtung (51, 52) aufweist, **dadurch gekennzeichnet,**
- **dass** zumindest in einem Teilbereich des Körpers des piezoelektrischen Mehrschicht-Bauelements die Innenelektroden (21, 22) jeweils mindestens zwei parallel geschaltete Teilelektroden (211, 222) aufweisen, die in einer gemeinsamen Vertiefung (41, 42) münden und über die elektrisch leitfähige Beschichtung (51, 52) dieser Vertiefung leitend miteinander verbunden sind.

2. Bauelement nach Anspruch 1,
- wobei die jeweilige Vertiefung (41, 42) sich entlang der Kante der Innenelektrode erstreckt, die in dieser Vertiefung mündet.

3. Bauelement nach einem der Ansprüche 1 bis 2,
- wobei für jede Innenelektrode (21, 22) eine eigene Vertiefung (41, 42) vorgesehen ist.

4. Bauelement nach einem der Ansprüche 1 bis 3,
- wobei die Tiefe der Vertiefung (41, 42) ein Zehntel des Abstands (L) zwischen aufeinander folgenden, unterschiedlich gepolten Innenelektroden (21, 22) nicht überschreitet.

5. Bauelement nach einem der Ansprüche 1 bis 4,
- wobei in jeder Vertiefung (41, 42) ein Anschlussdraht (61, 62) befestigt ist.

6. Bauelement nach Anspruch 5,
- wobei die Anschlussdrähte, die ein und derselben Polarität zugeordnet sind, alle an einen gemeinsamen elektrischen Anschluss angeschlossen sind.

7. Bauelement nach einem der Ansprüche 1 bis 6,
- wobei die Innenelektroden (21, 22) erste Innenelektroden (21) und zweite Innenelektroden (22) umfassen, die abwechselnd angeordnet sind,
- wobei die Vertiefungen (41), in die die ersten Innenelektroden (21) münden, an einer ersten Seitenfläche (31) und die Vertiefungen (42), in die die zweiten Innenelektroden (22) münden, an einer der ersten Seitenfläche gegenüberliegenden zweiten Seitenfläche (32) des Körpers angeordnet sind.

8. Bauelement nach einem der Ansprüche 1 bis 7,
- wobei die Oberfläche des Körpers, die senkrecht zu den Innenelektroden verläuft, frei ist von Metallisierungen bis auf die elektrisch leitfähige Beschichtung (51, 52) der Vertiefungen und/oder die frei liegenden Kanten der Innenelektroden (21, 22).

9. Bauelement nach einem der Ansprüche 1 bis 8,
- wobei der Teilbereich des Körpers des piezoelektrischen Mehrschicht-Bauelements ein Ausgangsteil (82), insbesondere ein Hochspannungsteil des piezoelektrischen Mehrschicht-Bauelements ist.

10. Bauelement nach einem der Ansprüche 1 bis 9,
- wobei zwischen zwei Teilelektroden (211, 222) der jeweiligen Innenelektrode eine elektrisch isolierende Schicht angeordnet ist.

11. Bauelement nach einem der Ansprüche 1 bis 10,
- wobei die Piezoschichten Keramik enthalten.

## Claims

1. Piezoelectric multilayer component
- with a body, in which piezo layers (1) and inner electrodes (21, 22) are arranged alternately,
- at least one edge of the respective inner electrode leading out into a depression (41, 42) formed on the surface of the body, the inner electrode being externally contacted at the depression,
- the surface of the respective depression (41, 42) having an electrically conductive coating (51, 52), **characterized**
- **in that**, at least in a partial region of the body of the piezoelectric multilayer component, the inner electrodes (21, 22) each have at least two parallel-connected part-electrodes (211, 222), which lead out in a common depression (41, 42) and are connected to one another in a conducting manner by means of the electrically conductive coating (51, 52) of this depression.

2. Component according to Claim 1,
- the respective depression (41, 42) extending along the edge of the inner electrode that leads out in this depression.

3. Component according to either of Claims 1 and 2,
- each inner electrode (21, 22) being provided with its own depression (41, 42).

4. Component according to one of Claims 1 to 3,
- the depth of the depression (41, 42) not exceeding one tenth of the distance (L) between successive, differently poled, inner electrodes (21, 22).

5. Component according to one of Claims 1 to 4
- a terminal wire (61, 62) being fastened in each depression (41, 42).

6. Component according to Claim 5,
- the terminal wires that are assigned one and the same polarity all being connected to a common electrical terminal.

7. Component according to one of Claims 1 to 6,
- the inner electrodes (21, 22) comprising first inner electrodes (21) and second inner electrodes (22), which are arranged alternately,
- the depressions (41), into which the first inner electrodes (21) lead out, being arranged on a first side face (31) and the depressions (42), into which the second inner electrodes (22) lead out, being arranged on a second side face (32) of the body that is opposite from the first side face.

8. Component according to one of Claims 1 to 7,
- the surface of the body that runs perpendicularly in relation to the inner electrodes being free of metallizations apart from the electrically conductive coating (51, 52) of the depressions and/or the exposed edges of the inner electrodes (21, 22).

9. Component according to one of Claims 1 to 8,
- the partial region of the body of the piezoelectric multilayer component being an output part (82), in particular a high-voltage part, of the piezoelectric multilayer component.

10. Component according to one of Claims 1 to 9,
- an electrically insulating layer being arranged between two part-electrodes (211, 222) of the respective inner electrode.

11. Component according to one of Claims 1 to 10,
- the piezo layers containing ceramic.

## Revendications

1. Composant multicouche piézoélectrique comprenant
- un corps, dans lequel des couches piézoélectriques (1) et des électrodes intérieures (21, 22) sont disposées en alternance,
- au moins une arête de l'électrode intérieure respective débouchant dans une cavité (41, 42) réalisée sur la surface du corps, l'électrode intérieure étant mise en contact sur la cavité vers l'extérieur,
- la surface de la cavité (41, 42) respective présentant un revêtement (51, 52) électroconducteur,
**caractérisé en ce que**
- les électrodes intérieures (21, 22) présentent à chaque fois au moins dans une zone partielle du corps du composant multicouche piézoélectrique au moins deux électrodes partielles (211, 222) branchées en parallèle, qui débouchent dans une cavité (41, 42) commune et sont reliées l'une à l'autre par le revêtement (51, 52) électroconducteur de cette cavité.

2. Composant selon la revendication 1,
- la cavité (41, 42) respective s'étendant le long de l'arête de l'électrode intérieure qui débouche dans cette cavité.

3. Composant selon l'une quelconque des revendications 1 à 2,
- une propre cavité (41, 42) étant prévue pour chaque électrode intérieure (21, 22).

4. Composant selon l'une quelconque des revendications 1 à 3,
- la profondeur de la cavité (41, 42) ne dépassant pas un dixième de la distance (L) entre des électrodes intérieures (21, 22) qui se suivent et polarisées de façon différente.

5. Composant selon l'une quelconque des revendications 1 à 4,
- un fil de branchement (61, 62) étant fixé dans chaque cavité (41, 42).

6. Composant selon la revendication 5,
- les fils de branchement, qui sont associés à une seule et même polarité, étant tous raccordés à un branchement électrique commun.

7. Composant selon l'une quelconque des revendications 1 à 6,
- les électrodes intérieures (21, 22) comprenant des premières électrodes intérieures (21) et des secondes électrodes intérieures (22), qui sont disposées en alternance,
- les cavités (41), dans lesquelles les premières électrodes intérieures (21) débouchent, étant disposées sur une première surface latérale (31) et les cavités (42), dans lesquelles les secondes électrodes intérieures (22) débouchent, étant disposées sur une seconde surface latérale (32), faisant face à la première surface latérale, du corps.

8. Composant selon l'une quelconque des revendications 1 à 7,
- la surface du corps, qui est agencée perpendiculairement aux électrodes intérieures, étant débarrassée des métallisations à l'exception du revêtement (51, 52) électroconducteur des cavités et/ou des arêtes disposées librement des électrodes intérieures (21, 22).

9. Composant selon l'une quelconque des revendications 1 à 8,
- la zone partielle du corps du composant multicouche piézoélectrique étant une partie de sortie (82), en particulier une partie à haute tension du composant multicouche piézoélectrique.

10. Composant selon l'une quelconque des revendications 1 à 9,
- une couche électro-isolante étant disposée entre deux électrodes partielles (211, 222) de l'électrode intérieure respective.

11. Composant selon l'une quelconque des revendications 1 à 10,
- les couches piézoélectriques contenant de la céramique.
